# EUROPÄISCHE PATENTSCHRIFT

(11) **EP 0 757 796 B1**
(45) Veröffentlichungstag und Bekanntmachung des Hinweises auf die Patenterteilung: **03.06.1998**
(21) Anmeldenummer: 95917338.6
(22) Anmeldetag: 19.04.1995
(51) Int. Cl.: G01R 1/06, G01R 15/16

(54) **VORRICHTUNG ZUM VERBINDEN EINES SPANNUNGSANZEIGEGERÄTES MIT EINEM SENSOR**
DEVICE FOR CONNECTING A VOLTAGE DISPLAY APPARATUS TO A SENSOR
DISPOSITIF POUR RACCORDER UN INDICATEUR DE TENSION A UN DETECTEUR

(30) Priorität: 20.04.1994 DE 9406553 U
(43) Veröffentlichungstag der Anmeldung: 12.02.1997
(73) Patentinhaber: KARL PFISTERER ELEKTROTECHNISCHE SPEZIALARTIKEL GMBH & CO. KG, 70327 Stuttgart (DE)
(72) Erfinder: SCHUSTER, Martin, D-73733 Esslingen (DE); RAMMLER, Wolfgang, D-70569 Stuttgart (DE); RINGERING, Theo, D-82490 Farchant (DE); JAKOBS, Hans, D-70195 Stuttgart (DE); ZUBER, Wolfgang, D-71334 Waiblingen (DE); VOGT, Stefanie, D-71397 Leutenbach (DE)
(74) Vertreter: Patentanwälte Bartels und Partner
(86) Internationale Anmeldenummer: EP9501469
(87) Internationale Veröffentlichungsnummer: WO9529405

(56) Entgegenhaltungen:
- WO-A-81/00792
- DE-A- 3 641 144
- GB-A- 2 183 910
- PATENT ABSTRACTS OF JAPAN vol. 8 no. 169 (P-292) [1606] ,4.August 1984 & JP,A,59 065269 (SUMITOMO DENKI) 13.April 1984,

## Beschreibung

Die Erfindung betrifft eine Vorrichtung zum Verbinden eines Spannungsanzeigegerätes mit einem kapazitiv an einen Leiter eines Hochspannungsenergieversorgungssystems angekoppelten Sensor, mit einer Schaltungsanordnung, die einen Eingang für die vom Sensor gelieferte elektrische Spannung und einen Ausgang für den Anschluß des Spannungsanzeigegerätes hat.

Bei den bekannten Vorrichtungen dieser Art kann es zu einer falschen Spannungsanzeige kommen, weil eine falsche Schaltungsauslegung nicht ausgeschlossen und kein ausreichender Schutz gegen äußere Störeinflüsse vorhanden ist und die verwendeten Verbindungsleitungen nicht auf die vom Sensor gelieferte Spannung abgestimmt sind.

Der Erfindung liegt daher die Aufgabe zugrunde, eine verbesserte Vorrichtung der eingangs genannten Art zu schaffen. Diese Aufgabe löst eine Vorrichtung mit den Merkmalen des Anspruches 1.

Durch die Ausführung der Vorrichtung als konfektioniertes Modul steht dem Anwender eine Baugruppe zur Verfügung, die vom Hersteller einer Kontrolle unterzogen werden kann, so daß eine Einhaltung der vorgegebenen elektrischen Daten gewährleistet ist, und die zuverlässig und dauerhaft gegen äußere Störeinflüsse geschützt ist und nur noch mit dem Sensor einerseits sowie dem Spannungsanzeigegerät andererseits mittels der vorgesehenen Steckverbindungen verbunden zu werden braucht, sowie einfach zu handhaben und am Einsatzort einzubauen ist.

Aus der DE-A-36 41 144, von der ausgehend der Oberbegriff des Anspruches 1 gebildet worden ist, ist ein Spitzenspannungsmeßgerät zur Messung von Zündspannungen an fremdgezündeten Brennkraftmaschinen bekannt. Dieses weist einen Tastkopf auf, welcher leitend mit der Zündkerze verbindbar ist, und von dem ein Erdungsanschluß und ein Koaxialkabel zu einem Spannungsanzeigegerät herausgeführt sind. Da die Schaltungsanordnung zur Umsetzung der Spannung innerhalb des Spannungsanzeigegerätes angeordnet ist ohne eine definierte Schnittstelle, ist eine Verwendung von handelsüblichen Spannungsanzeigegeräten nicht möglich. Das für die Fehlersuche gedachte Gerät ist aufgrund der Ausbildung seiner Isolation und der Abdichtungen nicht geeignet, bei den in Hochspannungsenergieversorgungssystemen auftretenden Leistungen eine Dauerspannungsanzeige bei Abschirmung der Störeinflüsse zu gewährleisten.

Erfindungsgemäß sind die Steckbuchsen bezüglich der den Zugang zu ihnen gestattenden Frontseite des Gehäuses in dieses hinein versetzt angeordnet, wobei von der Frontseite je ein Kanal zu den Steckbuchsen verläuft, der durch eine einstückig mit der Frontseite ausgebildete, elektrisch isolierende Materialplatte begrenzt ist. Solche Kanäle ermöglichen in einfacher Weise die Realisierung eines dichten und somit das Auftreten von Kriechströmen verhindernden Verschlusses, was vorteilhaft ist, weil der Isolationswiderstand der Steckbuchsen mehrere hundert Megaohm betragen muß. Deshalb sind die Innenwandflächen der zu den Steckbuchsen führenden Kanäle zumindest auf einem Teil der Kanallänge als Dichtungsfläche für eine Anlage je eines elektrisch isolierenden Dichtungskörpers ausgebildet, der einen Steckerstift des Spannungsanzeigegerätes konzentrisch umgibt und eine korrespondierende Ringzone bildet.

Dabei verjüngen sich die die Dichtungsfläche der Kanäle bildenden Ringzonen von der Frontseite des Gehäuses her konisch zu den Steckbuchsen hin, wobei die Dichtungskörper der Steckerstifte des Spannungsanzeigegerätes korrespondierende konische Ringzonen aufweisen.

Aus der GB-A-2 183 910 ist eine kapazitive Fernsehantennen-Ankoppelanordnung bekannt, bei der vorgesehen sind:
- ein vom die Anordnung umschließenden Gehäuse abgehendes, an seinem einen Ende mit dem Eingang der Anordnung verbundenes Koaxialkabel, an dessen anderem Ende ein Stecker vorgesehen ist,
- wenigstens ein den Ausgang der Anordnung bildendes Steckbuchsenpaar, wobei die Steckbuchsen bezüglich der den Zugang zu ihnen gestattenden Frontseite des Gehäuses in dieses hinein versetzt angeordnet sind.

Die hohen Anforderungen an die Qualität der Isolation der Spannung führenden Teile und an die Unempfindlichkeit gegen äußere Störeinflüsse lassen sich ohne Schwierigkeiten erfüllen, wenn nicht nur die Schaltungsanordnung und die Steckbuchsen, sondern auch das eine Ende des Koaxialkabels und der Erdungsleitung in das das Gehäuse bildende Isoliermaterial eingebettet sind, das Gehäuse also einen einstückigen Block bildet. Dieser Block ist vorzugsweise ein Spritzgußteil aus einem thermoplastischen Kunststoff.

Vorteilhafterweise ist die Frontseite des Gehäuses von einer zurückversetzten Anlagefläche berandet. Das Gehäuse kann dann in einfacher Weise an einer Trägerplatte oder dergleichen festgelegt werden, da die über die Anlagefläche vorspringende Partie des Gehäuses nur durch eine Öffnung der Trägerplatte hindurchgesteckt zu werden braucht. Besonders einfach ist die Festlegung des Gehäuses an einer solchen Trägerplatte dann, wenn die Mantelfläche des über die Anlagefläche vorspringenden Teils des Gehäuses mit einer nutartigen Vertiefung für den Eingriff der Schenkel eines Bügels versehen ist, zwischen dem und der Anlagefläche die Trägerplatte liegt.

Im folgenden ist die Erfindung anhand eines in der Zeichnung dargestellten Ausführungsbeispiels im einzelnen erläutert. Es zeigen:
- Fig. 1: eine Seitenansicht des vollständigen Ausführungsbeispiels,
- Fig. 2: eine andere Seitenansicht des Gehäuses,
- Fig. 3: eine Ansicht auf die Frontseite von zwei gleichen, an einer Trägerplatte festgelegten Gehäusen,
- Fig. 4: einen Längsschnitt des Gehäuses des Ausführungsbeispiels.

Es ist bekannt, einen Spannungssensor in Form einer Elektrode kapazitiv an einen Leiter eines Hochspannungsenergieversorgungsnetzes anzukoppeln. Solche Sensoren werden vor allem dann eingesetzt, wenn der Leiter von einer Isolation umgeben ist und deshalb für eine Kontaktierung nicht zur Verfügung steht. Deshalb werden auch Kabelstecker und/oder die zugehörigen Steckbuchsen häufig mit solchen Sensoren versehen. Bekannt sind ferner Spannungsanzeigegeräte, mittels deren aufgrund der von einem solchen Sensor gelieferten Spannung ein optisches Blinksignal erzeugt wird. Es kann dann ständig überprüft werden, ob der Leiter des Hochspannungsenergieversargungssystems seine Betriebsspannung führt.

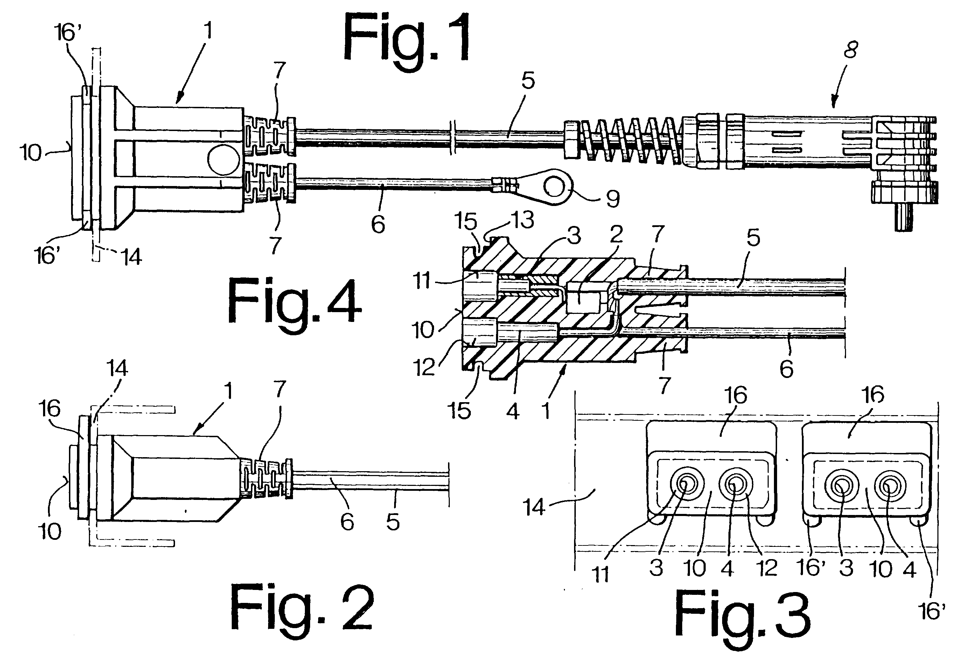

Für die Verbindung des Spannungsanzeigegerätes, das zwei Steckerstifte aufweist, mit einer Steckbuchse, welche an den Sensor angeschlossen ist, ist ein konfektioniertes Schnittstellenmodul vorgesehen, das als ein einstückiger Block aus einem Kunststoff mit hoher Isolationsfähigkeit ausgebildetes Gehäuse 1 aufweist. In dieses Gehäuse 1 sind eine Schaltungsanordnung 2, zwei Steckbuchsen 3 und 4 sowie die Enden eines Koaxialkabels 5 und einer Erdungsleitung 6 eingebettet, wie Fig. 4 zeigt. An diejenige Stirnseite des Gehäuses 1, aus der das Koaxialkabel 5 und die Erdungsleitung 6 austreten, ist je eine elastische Tülle 7 angeformt, welche die mit dem Gehäuse 1 verbundenen Endabschnitte des Koaxialkabels 5 und der Erdungsleitung 6 aufnehmen.

Die Schaltungsanordnung 2 enthält einen Überspannungsableiter und parallel zu diesem wenigstens einen Kondensator. Mit dem Eingang der Schaltungsanordnung 2 ist der zentrale Leiter des Koaxialkabels 5 verbunden, an dessen anderem Ende ein Stecker 8 vorgesehen ist, der mit der Steckbuchse kuppelbar ist, an welche die den Sensor bildende Elektrode angeschlossen ist. Die Schaltungsanordnung 2 liegt einseitig auf Masse. Mit dieser ist das eine Ende der Erdungsleitung 6 verbunden, deren anderes Ende im Ausführungsbeispiel mit einem Kabelschuh 9 versehen ist, der eine qualitativ hochwertige Verbindung mit einem auf Nullpotential liegenden Körper ermöglicht. Der im Falle eines Ansprechens des Überspannungsableiters auftretende Strom kann deshalb über die Erdungsleitung 6 abgeleitet werden, ohne daß die Gefahr einer unzulässigen Spannungserhöhung auftritt.

Diejenige Seite des Gehäuses 1, welche der die Tüllen 7 tragenden Seite abgewandt ist, bildet eine rechteckförmige Frontseite 10. Gegenüber dieser Frontseite 10 sind, wie Fig. 4 zeigt, die beiden Steckbuchsen 3 und 4 zurückversetzt angeordnet, von denen erstere mit dem im Betrieb spannungführenden Ausgang der Schaltungsanordnung 2 und letztere mit einem Massepunkt der Schaltungsanordnung 2 verbunden ist. Der Abstand zwischen den beiden Steckbuchsen 3 und 4 und damit auch zwischen zwei auf diese ausgerichteten Kanälen 11 bzw. 12, welche sich von der Frontseite 10 zu den Steckbuchsen 3 bzw. 4 erstrecken, ist gleich dem Abstand gewählt, den die beiden Steckerstifte des nicht dargestellten Spannungsanzeigegerätes aufweisen, da diese in die Steckbuchsen 3 und 4 eingesteckt werden. Die beiden Kanäle 11 und 12 verjüngen sich leicht konisch zu den Steckbuchsen 3 bzw. 4 hin und bilden je eine konische Dichtungsfläche. Wenn die Steckerstifte des Spannungsanzeigegerätes in die Steckbuchsen 3 und 4 eingesteckt sind, liegen an diesen Dichtungsflächen korrespondierend ausgebildete Dichtungsflächen von Dichtungskörpern an, welche die beiden Steckerstifte des Spannungsanzeigegerätes auf einem Teil ihrer Länge umgeben. Diese Steckerstifte verschließen deshalb zusammen mit den Dichtungskörpern die Kanäle 11 und 12 elektrisch dicht, so daß auch über die Kanäle 11 und 12 keine Feuchtigkeit zu den sich im Gehäuse 1 befindenden leitenden Teilen gelangen kann.

Gegenüber der Frontseite 10 ist eine rahmenförmige Anlagefläche 13 des Gehäuses 1 in der gleichen Richtung wie die Steckbuchsen 3 und 4 zurückversetzt. An dieser Anlagefläche 13 liegt eine Trägerplatte 14 an, wenn der quaderförmige, über die Anlagefläche 13 vorspringende Teil des Gehäuses 1 eine entsprechend rechteckförmig ausgebildete Öffnung der Trägerplatte 14 durchdringt. Die sich von der Anlagefläche 13 zu der Frontseite 10 erstreckende Materialpartie des Gehäuses 1 weist in ihrer Mantelfläche eine umlaufende Nut 15 auf, deren Abstand von der Anlagefläche 13 der Dicke der Trägerplatte 14 entspricht. In die Nut 15 werden die Schenkel 16' eines Befestigungsbügels 16 eingeführt, zwischen dem und der Anlagefläche 13 die Trägerplatte 14 festgeklemmt wird. Die Festlegung des Gehäuses 1 an der Trägerplatte 14 ist also äußerst einfach.

Wie Fig. 3 zeigt, können wegen der geringen Abmessungen des Gehäuses 1 problemlos mehrere Gehäuse 1 nebeneinander an der Trägerplatte 14 festgelegt werden, bei der es sich beispielsweise um den Jochabschnitt einer im Querschnitt U-förmigen Schiene handeln kann.

Bei dem vorstehend beschriebenen Ausführungsbeispiel erfolgt die Montage des Gehäuses 1 von der Rückseite der Trägerplatte 14 her. Ist eine Montage von der Vorderseite her erwünscht, kann man statt der Erdungsleitung einen Erdungsbolzen vorsehen, der vorzugsweise gleichachsig zu der auf Erdpotential zu legenden Steckbuchse angeordnet ist und über die der Frontseite 10 entgegengesetzte Rückseite des Gehäuses übersteht. Der Bolzen oder, wenn dieser von der Rückseite der zu erdenden Buchse absteht, diese direkt können dann durch eine Schraubverbindung elektrisch leitend mit der geerdeten Trägerplatte verbunden werden. Diese Verschraubung kann auch dazu verwendet werden, über ein elektrisch leitendes Verbindungselement den Schirm des Koaxialkabels zu erden. Sofern es nicht möglich ist, den am anderen Ende des Koaxialkabels vorgesehenen Stecker durch die Öffnung in der Trägerplatte hindurchzuführen, wird man bei einer Montage des Gehäuses von vorne her in Verlängerung der mit dem Koaxialkabel zu verbindenden Buchse eine Klemmhülse oder dergleichen vorsehen, mittels deren eine elektrisch leitende und mechanisch feste Verbindung mit dem Innenleiter des Koaxialkabels hergestellt werden kann.

Das Koaxialkabel kann nicht nur in Richtung der mit ihm verbundenen Buchse vom Gehäuse weggeführt werden. Man kann auch das Koaxialkabel im rechten Winkel zu dieser Steckbuchse, also parallel zur Trägerplatte wegführen.

Schließlich ist es zwar vorteilhaft, aber nicht notwendig, das gehäuseseitige Ende des Koaxialkabels in das Gehäuse einzubetten. Wie bereits erwähnt, kann das Koaxialkabel auch außerhalb des Gehäuses mit der zugeordneten Buchse verbunden sein. Diese Verbindung kann auch in Form einer Steckverbindung ausgebildet sein.

## Patentansprüche

1. Vorrichtung zum Verbinden eines Spannungsanzeigegerätes mit einem kapazitiv an einen Leiter eines Hochspannungsenergieversorgungssystems angekoppelten Sensor, mit einer Schaltungsanordnung (2), die einen Eingang für die vom Sensor gelieferte elektrische Spannung und einen Ausgang für den Anschluß des Spannungsanzeigegerätes hat, wobei vorgesehen sind:
a) ein konfektioniertes Modul mit einem geschlossenen, die Schaltungsanordnung (2) enthaltenden Gehäuse (1),
b) ein mit einem Massepunkt der Schaltungsanordnung (2) verbundener Erdungsanschluß (6),
dadurch gekennzeichnet, daß ferner vorgesehen sind:
c) ein vom Gehäuse (1) abgehendes, an seinem einen Ende mit dem Eingang der Schaltungsanordnung (2) verbundenes Koaxialkabel (5), an dessen anderem Ende ein Stecker (8) vorgesehen ist,
d) wenigstens ein den Ausgang der Schaltungsanordnung (2) bildendes Steckbuchsenpaar (3, 4) zur Herstellung einer Steckverbindung mit dem Spannungsanzeigegerät, wobei die Steckbuchsen (3, 4) bezüglich der den Zugang zu ihnen gestattenden Frontseite (10) des Gehäuses (1) in dieses hinein versetzt angeordnet sind,
e) für jede vorgesehene Steckbuchse (3, 4) je ein Kanal (11, 12), der von der Frontseite (10) zu der zugeordneten Steckbuchse (3, 4) geführt ist und der durch eine einstückig mit der Frontseite (10) ausgebildete, elektrisch isolierende Materialpartie begrenzt ist, wobei die Innenwandfläche wenigstens eines dieser kanäle (11, 12) auf einem Teil der Kanallänge eine sich zur Steckbuchse (3, 4) hin verjüngende, konische Ringzone als Dichtungsfläche für eine dichte Anlage eines elektrisch isolierenden Dichtungskörpers aufweist, der einen Steckerstift des Anzeigegerätes konzentrisch umgibt und eine korrespondierende konische Ringzone bildet.

2. Vorrichtung nach Anspruch 1, dadurch gekennzeichnet, daß die Frontseite (10) des Gehäuses von einer gegen den Zentralbereich des Gehäuses (1) hin zurückversetzten Anlagefläche (13) umgeben ist.

3. Vorrichtung nach Anspruch 2, dadurch gekennzeichnet, daß die Mantelfläche des die Anlagefläche (13) mit der Frontseite 10 verbindenden Teils des Gehäuses (1) mit einer Nut (15) für den Eingriff der Schenkel (16') eines Bügels (16) versehen ist, der das Gehäuse (1) sichert, wenn dieser Teil in eine Öffnung einer Trägerplatte (14) bis zur Anlage der Trägerplatte (14) an der Anlagefläche (13) eingeführt ist.

4. Vorrichtung nach einem der Ansprüche 1 bis 3, dadurch gekennzeichnet, daß das Gehäuse (1) als einstückiger Block ausgebildet ist, in den die Steckbuchsen (3, 4), die Schaltungsanordnung (2) und das eine Ende des Koaxialkabels (5) und einer Erdungsleitung eingebettet sind.

5. Vorrichtung nach einem der Ansprüche 1 bis 4, dadurch gekennzeichnet, daß der Erdungsanschluß durch eine vom Gehäuse (1) abgehende Erdungsleitung (6) gebildet ist.

6. Vorrichtung nach einem der Ansprüche 1 bis 4, dadurch gekennzeichnet, daß der Erdungsanschluß durch einen vom Gehäuse abstehenden Bolzen gebildet ist, der mit einer geerdeten Trägerplatte elektrisch verbindbar ist.

7. Vorrichtung nach Anspruch 6, dadurch gekennzeichnet, daß der Schirm des Koaxialkabels elektrisch leitend mit dem Bolzen verbunden ist.

8. Vorrichtung nach einem der Ansprüche 1 bis 7, dadurch gekennzeichnet, daß das Koaxialkabel parallel zu den Buchsen des Steckbuchsenpaares oder im rechten Winkel *zu* diesen vom Gehäuse abgeht.

9. Vorrichtung nach einem der Ansprüche 1 bis 8, dadurch gekennzeichnet, daß das Gehäuse (1) ein Spritzgußteil aus einem thermoplastischen Kunststoff ist und die elektrischen Elemente in diesem Kunststoff eingebettet sind.

## Claims

1. Device for connecting a voltage display apparatus to a sensor which is capacitively coupled to a conductor of a high-voltage power supply system, comprising a circuit (2) which has an input for the electrical voltage delivered by the sensor and an output for connecting the voltage display apparatus, there being provided:
a) a preassembled module having a closed housing (1) containing the circuit (2),
b) an earthing connection (6) connected to a ground point of the circuit (2),
characterised by the fact that there are further provided:
c) a coaxial cable (5) which emerges from the housing (1) and is connected at one end to the input of the circuit (2) and which is provided at its other end with a connector plug (8),
d) at least cne socket-contact pair (3, 4) forming the output of the circuit (2), to produce a plug connection with the voltage display apparatus, the socket contacts (3, 4) being offset into the housing (1) relative to the front panel (10) thereof which allows access to them,
e) for each socket contact provided (3, 4), a respective duct (11, 12) running from the front panel (10) to the associated socket contact (3, 4) and delimited by an electrically insulating portion of material of integral construction with the front panel (10); along part of the length of the duct the internal wall surface of at least one of these ducts (11, 12) features a cone-shaped annular zone which tapers towards the socket contact (3, 4) to act as a sealing surface for sealingly seating an electrically insulating sealing body which concentrically surrounds a contact pin on the display apparatus and forms a corresponding cone-shaped annular zone.

2. Device according to claim 1, characterised in that the front panel (10) of the housing is surrounded by a contact surface (13) which is set back towards the central region of the housing (1).

3. Device according to claim 2, characterised in that the casing surface of that part of the housing (1) which connects the contact surface (13) to the front panel (10) is provided with a groove (15) for engaging the side-pieces (16') of a bow (16) which secures the housing (1) once said part has been introduced into an opening in a support plate (14) until the support plate (14) comes up against the contact surface (13).

4. Device according to any of claims 1 to 3, characterised in that the housing (1) is in the form of a one-piece block into which are embedded the socket contacts (3, 4), the circuit (2) and one end of the coaxial cable (5) and of an earthing lead.

5. Device according to any of claims 1 to 4, characterised in that the earthing connection is constituted by an earthing lead (6) which emerges from the housing (1).

6. Device according to any of claims 1 to 4, characterised in that the earthing connection is constituted by a stud which protrudes from the housing and is adapted to be connected electrically to an earthed support plate.

7. Device according to claim 6, characterised in that the shield of the coaxial cable is connected in electrically conductive manner to the stud.

8. Device according to any of claims 1 to 7, characterised in that the coaxial cable emerges from the housing parallel to the sockets of the socket-contact pair or at a right angle thereto.

9. Device according to any of claims 1 to 8, characterised in that the housing (1) is injection moulded from a thermoplastic polymer and the electrical elements are embedded in this polymer.

## Revendications

1. Dispositif pour relier un dispositif indicateur de tension à un capteur couplé de manière capacitive à un système de fourniture d'énergie sous haute tension, muni d'un arrangement de montage (2), lequel possède une entrée pour la tension électrique fournie par le capteur et une sortie pour le raccordement au dispositif indicateur de tension, dans lequel sont prévus :
a) un module confectionné avec un boîtier (1) fermé, contenant l'arrangement de montage (2),
b) un câble coaxial (5) s'éloignant du boîtier (1), l'une des ses extrémités étant reliée à l'entrée de l'arrangement de montage (2), l'autre extrémité étant pourvue d'une fiche de raccordement (8),
c) un raccord de mise à la terre (6) connecté à un point de masse de l'arrangement de montage (2),
d) au moins une paire de fiches mâles (3, 4) formant la sortie de l'arrangement de montage (2) pour mettre en oeuvre une connexion par fiches au dispositif indicateur de tension, dans lequel les fiches mâles (3, 4), relatives à la partie frontale (10) du boîtier (1) permettant l'accès à ces dernières, sont agencées de manière enfoncée dans celle-ci,
e) pour chaque fiche mâle (3, 4) prévue, un canal (11, 12), qui va de la partie frontale (10) à la fiche mâle adjointe (3, 4) et qui est délimité au moyen d'une pièce en matière isolante au plan électrique, d'un seul tenant avec la partie frontale (10), la paroi interne de l'un de ces canaux (11, 12), présente par conséquent, sur au moins une partie de la longueur du canal s'effilant de façon à pouvoir entrer dans la fiche mâle (3, 4), une zone annulaire conique comme surface de contact pour procurer un agencement étanche d'un corps isolant procurant l'étanchéité, lequel entoure de manière concentrique une fiche de guidage du dispositif indicateur de tension et forme une zone annulaire conique correspondante.

2. Dispositif conforme à la revendication 1, caractérisé en ce que la partie frontale (10) du boîtier est entourée d'une face de départ (13) qui revient en arrière dans la partie centrale du boîtier (1).

3. Dispositif conforme à la revendication 2, caractérisé en ce que la surface latérale de la face de départ (13), reliée à la partie frontale (10) de la partie du boîtier (1) est fournie avec une rainure (15) pour la mise en oeuvre du bras (16') d'un étrier (16), lequel assure le boîtier (1), lorsque cette partie est introduite dans une ouverture d'une plaque de support (14) jusqu'à ce que la plaque de support (14) engage la face de départ (13).

4. Dispositif selon l'une des revendications 1 à 3, caractérisé en ce que le boîtier (1) est construit sous forme d'un bloc d'un seul tenant, dans lequel sont encastrés les fiches de raccordement (3, 4), l'agencement de montage (2) et l'une des extrémités du câble coaxial et d'un conducteur de mise à la terre.

5. Dispositif selon l'une des revendications 1 à 4, caractérisé en ce que la connexion de mise à la terre est formée d'un conducteur de mise à la terre (6) partant du boîtier (1).

6. Dispositif selon l'une des revendications 1 à 4, caractérisé en ce que la connexion de mise à la terre est formée d'un boulon s'éloignant du boîtier, lequel peut être relié de manière électrique à une plaque de support mise à la terre.

7. Dispositif selon la revendication 6, caractérisé en ce que l'écran du câble coaxial est relié au boulon de manière à conduire l'électricité.

8. Dispositif selon l'une des revendications 1 à 7, caractérisé en ce que le câble coaxial part du boîtier en étant parallèle aux fiches de la paire de fiches ou en formant un angle droit avec celles-ci.

9. Dispositif selon l'une des revendications 1 à 8, caractérisé en ce que,
le boîtier (1) est une pièce de moulage faite dans une matière thermoplastique, et les éléments électriques sont encastrés dans cette matière plastique.
